(19) Europäisches Patentamt

European Patent Office

Office européen des brevets

(11) EP 0 781 257 B1

(12) FASCICULE DE BREVET EUROPEEN

(45) Date de publication et mention
de la délivrance du brevet:
06.06.2001 Bulletin 2001/23

(51) Int Cl.⁷: C03C 17/34, C03C 17/00

(21) Numéro de dépôt: 96924963.0

(22) Date de dépôt: 10.07.1996

(86) Numéro de dépôt international:
PCT/FR96/01073

(87) Numéro de publication internationale:
WO 97/03029 (30.01.1997 Gazette 1997/06)

(54) **VITRAGE MUNI D'UNE COUCHE CONDUCTRICE ET/OU BAS-EMISSIVE**

GLASSCHEIBE MIT LEITENDER UND/ODER GERING STRAHLENDER BESCHICHTUNG

GLAZING INCLUDING A CONDUCTIVE AND/OR LOW-EMISSIVE LAYER

(84) Etats contractants désignés:
AT BE CH DE DK FI FR GB IE IT LI LU NL SE

(30) Priorité: 12.07.1995 FR 9508421

(43) Date de publication de la demande:
02.07.1997 Bulletin 1997/27

(73) Titulaire: SAINT-GOBAIN GLASS FRANCE
92400 Courbevoie (FR)

(72) Inventeurs:
• BOIRE, Philippe
F-75015 Paris (FR)
• ZAGDOUN, Georges
F-92250 La Garenne-Colombes (FR)

(74) Mandataire: Renous Chan, Véronique
Saint-Gobain Recherche,
39, Quai Lucien Lefranc
93300 Aubervilliers (FR)

(56) Documents cités:
EP-A- 0 365 239        EP-A- 0 365 240
EP-A- 0 499 523        EP-A- 0 518 755
EP-A- 0 521 602        EP-A- 0 573 325
WO-A-85/00555         WO-A-94/25410
FR-A- 2 348 165        FR-A- 2 348 166
FR-A- 2 456 077        GB-A- 2 015 983
US-A- 4 187 336

**Description**

L'invention a trait à un vitrage comprenant un substrat en verre muni d'une couche mince fonctionnelle, cette dernière présentant des propriétés de transparence, de conductivité électrique et/ou de basse émissivité.

Elle concerne également les procédés d'obtention d'un tel vitrage, en particulier à l'aide de techniques de pyrolyse ou de techniques utilisant le vide.

Ce type de couche fonctionnelle trouve tout particulièrement application pour les vitrages destinés au bâtiment : revêtu d'une couche bas-émissive, un substrat de verre permet de réduire l'émission dans l'infrarouge lointain à travers le vitrage dont il fait partie, de l'intérieur vers l'extérieur du local. En réduisant les pertes énergétiques dues en partie à cette fuite de rayonnement, on améliore sensiblement le confort des habitants, notamment hiver. Le substrat ainsi revêtu puis associé à un autre substrat par l'intermédiaire d'une lame de gaz, la couche bas-émissive se trouvant en face 3, (en comptant à partir de la face la plus extérieure) constitue un double-vitrage isolant très efficace.

Ces couches trouvent également application pour les vitrages destinés à l'automobile, de par leurs propriétés de conduction électrique, par exemple pour former des vitrages chauffants en prévoyant des arrivées de courant.

Les couches d'oxydes métalliques présentant ces propriétés sont, par exemple, des couches d'oxyde d'indium dopé à l'étain (ITO), ou d'oxyde de zinc dopé à l'aluminium (ZnO:Al), à l'indium (ZnO:In), à l'étain (ZnO:Sn), ou au fluor (ZnO:F), ou d'oxyde d'étain dopé au fluor ($SnO_2$:F).

Ces couches d'oxyde métallique peuvent être obtenues par différents procédés : par des procédés sous vide (évaporation thermique, pulvérisation cathodique, éventuellement à l'aide de magnétron) ou par pyrolyse de composés organo-métalliques projetés par un gaz vecteur sous forme liquide, solide ou gazeuse sur la surface du substrat en verre chauffé à une température élevée mais néanmoins inférieure à sa température de ramollissement. Ceux-ci, mis ainsi en contact avec une surface chaude, se décomposent en s'oxydant pour former sur celle-ci une couche d'oxyde métallique. Cette dernière technique est tout particulièrement avantageuse dans la mesure où elle permet d'envisager des dépôts directement sur le ruban de verre d'une ligne de fabrication type float de manière continue.

Cependant, pour que ces couches atteignent un niveau de performance élevé, notamment en termes de valeurs d'émissivité et/ou de conduction électrique, leur épaisseur doit être d'au moins 180 nm voire au-delà de 400 nm, et usuellement comprise entre 350 et 550 nm. Une couche mince présentant de telles épaisseurs confère au substrat qu'elle revêt un aspect en réflexion, notamment une coloration, qui peut ne pas être très appréciée d'un point de vue esthétique.

Se pose ainsi le problème de l'aspect en réflexion, tout particulièrement de la coloration résiduelle obtenue, du substrat ainsi revêtu. En effet, selon l'enseignement du brevet EP-B-0 125 153, une couche d'oxyde d'étain dopé au fluor $SnO_2$:F dont l'épaisseur, faible, est d'environ 163 à 165 nm, déposée sur un substrat de verre float clair de 4 mm d'épaisseur confère à ce dernier une coloration en réflexion dans les bleus, coloration très appréciée actuellement aussi bien dans le domaine du bâtiment que de l'automobile. Par contre, il a été constaté qu'une couche de même nature mais cette fois d'une épaisseur de 360 nm, donc une couche présentant de meilleures performances, confère à un même substrat un aspect en réflexion « côté couche » dans les verts/pourpres, couleur qui est peu recherchée pour des raisons esthétiques.

Différentes solutions techniques visant à améliorer l'aspect optique de vitrages munis de couches fonctionnelles ayant de telles caractéristiques ont déjà été proposées. Ainsi, selon l'enseignement de la demande de brevet européen EP-A-0 573 325, on intercale entre substrat et couche fonctionnelle un revêtement dit « intermédiaire» dont on a sélectionné de manière adéquate l'épaisseur optique afin d'obtenir une couleur résiduelle en réflexion qui soit dans les bleus, et peu intense de surcroît. Dans un même but, la demande de brevet WO-94/25410 propose de disposer la couche fonctionnelle cette fois entre deux revêtements, l'un dit « interne », l'autre dit « externe », la combinaison du choix des caractéristiques d'épaisseur et d'indice de réfraction de ces deux revêtements élargissant les possibilités pour ajuster finement l'aspect colorimétrique en réflexion du vitrage.

L'invention a alors pour but d'améliorer encore ces empilements de couches minces, en mettant au point des vitrages qui puissent à la fois être munis de couches fonctionnelles présentant de bonnes propriétés thermiques/ électriques et présenter un aspect en réflexion le plus agréable possible à l'oeil, notamment ayant une couleur en réflexion esthétique, peu intense, peu réfléchissante et stable.

L'invention a également pour but la mise au point d'un procédé de fabrication de ces vitrages, ainsi que celle de l'installation nécessaire à sa mise en oeuvre.

L'invention a d'abord pour objet un vitrage comprenant un substrat transparent, notamment en verre, muni d'au moins une couche mince transparente fonctionnelle. Dans le contexte de l'invention, on comprend par « fonctionnelle » une couche possédant des propriétés de conduction électrique et/ou des propriétés thermiques, tout particulièrement des propriétés de bas-émissivité. Afin d'améliorer l'aspect optique, notamment sur le plan colorimétrique, du vitrage, on dispose entre le substrat et cette couche fonctionnelle au moins une couche dite « intermédiaire » présentant dans son épaisseur un gradient d'indice de réfraction décroissant. On comprend par « gradient décroissant » dans le sens de l'invention le fait que l'indice de réfraction de la couche diminue dans son épaisseur au fur et à mesure que l'on s'éloigne de la surface de son substrat porteur.

Selon un mode préféré de l'invention, on dépose en outre sur la couche fonctionnelle au moins une couche mince dite « externe » dont l'indice de réfraction, et l'épaisseur géométrique sont choisis afin de contribuer à l'amélioration de l'aspect optique du vitrage en combinaison avec la couche intermédiaire.

De manière surprenante, il s'est en effet avéré qu'intercaler entre substrat et couche fonctionnelle une couche dont l'indice de réfraction diminue progressivement avait un effet extrêmement positif sur l'aspect en réflexion du vitrage, à la fois sur le plan purement esthétique et sur le plan industriel : d'une part, le vitrage selon l'invention a une couleur en réflexion « côté couches » agréable, tout particulièrement dans la gamme des bleus, couleur très atténuée et « lavée de blanc », et de plus dépourvue d'aspect brillant car associée à une valeur de réflexion lumineuse très recherchée. Ces effets « anti-reflet » et « anti-couleur » se trouvent d'ailleurs accentués par la présence du revêtement « externe » précédemment mentionné.

Mais d'autre part, on s'est aperçu que cette couche intermédiaire spécifique à l'invention permettait d'améliorer également la stabilité, l'uniformité de l'aspect en réflexion du vitrage.

En effet, il est connu que suivant le mode de fabrication de dépôt de couches minces choisi, des tolérances dans les épaisseurs des couches sont fixées, tolérances au-delà desquelles l'oeil perçoit trop nettement des variations d'aspect d'un vitrage à l'autre ou d'une zone d'un vitrage à l'autre. Ces variations sont induites de manière interférentielle par l'irrégularité dans l'épaisseur des couches et tout particulièrement dans l'épaisseur de la couche fonctionnelle. Or, il s'est avéré que la couche intermédiaire spécifique à l'invention atténuait très sensiblement ces variations d'aspect, ce qui permettait, selon le mode de dépôt choisi, de diminuer significativement le taux de rebut des vitrages après dépôt des couches pour cause d'irisation/défaut d'aspect optique, ou, corollairement, d'adopter des tolérances de fabrication quant aux épaisseurs de couches moins draconiennes, ce qui est avantageux sur le plan de la qualité des vitrages ou de la rentabilité de leur fabrication.

De préférence, on choisit la variation totale d'indice de réfraction dans l'épaisseur de la couche intermédiaire selon l'invention d'une valeur au moins égale à 0,2, notamment comprise entre 0,25 et 0,80.

Ainsi, l'indice de réfraction le moins élevé dans ce gradient d'indice est de préférence compris entre 1,45 et 1,60, tandis que l'indice de réfraction le plus élevé est de préférence compris entre 1,70 et 2,35. La différence entre l'indice le moins élevé et l'indice le plus élevé est en effet à choisir relativement grande pour obtenir de manière optimale les effets avantageux de l'invention.

Un mode de réalisation préféré pour ce gradient d'indice consiste à faire décroître l'indice de réfraction de la couche intermédiaire d'une valeur proche de l'indice de réfraction de la couche fonctionnelle à une valeur proche de l'indice de réfraction du substrat.

L'épaisseur géométrique de la couche intermédiaire est quant à elle de préférence choisie entre 30 et 120 nm, par exemple entre 40 et 120 nm, notamment entre 45 et 90 nm ou entre 50 et 100 nm. L'épaisseur doit en fait être suffisante pour pouvoir réaliser effectivement le gradient d'indice.

Pour créer ce gradient d'indice, différentes possibilités existent. Le plus simple est de l'obtenir en faisant varier progressivement la composition chimique de la couche intermédiaire dans son épaisseur, notamment par un mélange d'au moins deux composants ayant des indices de réfraction différents, le taux de composant ou du mélange de composants à indice(s) le(s) plus élevé(s) décroissant graduellement dans son épaisseur. Le choix de ces composants peut par exemple être le suivant : pour le composant à indice peu élevé conviennent l'oxyde, l'oxynitrure ou l'oxycarbure de silicium, et pour les composants à indices plus élevés conviennent l'oxyde d'étain, de titane, de zirconium, d'aluminium, de magnésium ou de vanadium, de l'oxycarbure de silicium ou du nitrure de silicium ou un mélange d'au moins deux de ces composés.

Ce gradient peut être obtenu par une technique sous vide ou par pyrolyse,et tout particulièrement par pyrolyse en phase gazeuse. Pour ce faire, a été conçue selon l'invention une buse de distribution de gaz particulièrement adaptée. Cette buse est disposée au-dessus du verre et transversalement à son axe de défilement, quand il se présente sous la forme d'un ruban de verre float, et est disposée de préférence dans l'enceinte même du bain de flottage. Elle comporte un premier talon amont, un second talon amont, un bloc profilé central et un talon aval. Une première fente d'injection de gaz précurseur est ménagée entre les deux talons amont et une seconde fente d'injection est ménagée entre le bloc central et le talon aval. Une fente d'évacuation des effluents de gaz non réagis est ménagée entre le bloc profilé central et le talon aval. Ainsi, l'ensemble de ces fentes et les faces inférieures des talons et du bloc central guident les veines de gaz alimentant les deux fentes d'injection le long du verre dans une zone de dépôt, avec un trajet d'écoulement ayant approximativement la forme d'un U. Pour créer un mélange partiel et progressif entre ces deux veines de gaz dans la zone de dépôt, et ainsi créer le gradient de composition recherché, on règle certains paramètres géométriques de la buse. Les deux paramètres importants sont d'une part la distance I entre les fentes d'injection et d'autre part les configurations relatives des deux talons amont et du bloc central. De fait, pour parvenir à l'effet voulu, le mode de réalisation préféré consiste à ce que la face inférieure du bloc central soit surélevée par rapport à celle du second talon amont qui lui est adjacent, et que la face inférieure de ce second talon amont soit elle-même surélevée par rapport à celle du premier talon amont.

Quant à la distance I entre les deux fentes d'injection, il est avantageux de la choisir au plus égale aux 3/4 de la longueur totale de la zone de dépôt, notamment d'environ 1/4 à 2/3 de ladite longueur.

Pour obtenir le gradient d'indice de réfraction décroissant voulu pour fabriquer la couche intermédiaire selon l'invention, il faut alors alimenter la première fente d'injection avec le mélange réactionnel se pyrolysant sous la forme d'un oxyde d'indice de réfraction donné ayant l'indice le plus élevé ($TiO_2$, $SnO_2$, $ZrO_2$, $MgO$, $V_2O_5$, $SiO_xC_y$, $Si_3N_4$, mélange d'au moins deux des oxydes ou d'au moins un de ces oxydes avec $Al_2O_3$), la seconde fente d'injection étant alimentée avec le mélange réactionnel se pyrolysant sous la forme de l'oxyde ayant l'indice le plus faible (comme $SiO_2$).

Il faut bien sûr inverser les choses si l'on souhaite au contraire obtenir un gradient d'indice croissant.

L'invention concerne également le procédé de mise en oeuvre d'une telle buse, et les vitrages obtenus par ledit procédé.

En ce qui concerne la couche mince dite « externe » précédemment mentionnée et qui se trouve au-dessus de la couche fonctionnelle, on la choisit de préférence d'un indice de réfraction compris entre 1,4 et 1,7 et d'une épaisseur géométrique comprise entre 70 et 120 nm. C'est en effet avec de telles caractéristiques que l'on obtient l'aspect optique le meilleur, notamment la baisse de réflexion lumineuse $R_L$ la plus grande et donc, corollairement, l'augmentation de transmission lumineuse $T_L$ la plus importante. Pour la constituer, on peut choisir différents matériaux diélectriques, notamment à base d'au moins un des composés suivants : oxyde, oxynitrure ou oxycarbure de silicium, oxyde d'aluminium, mélange d'oxyde de silicium et d'aluminium comportant aussi un halogénure du type fluor.

Pour fabriquer cette couche, on peut avoir recours à une technique de dépôt sous vide, notamment du type pulvérisation cathodique réactive ou non. On peut aussi utiliser des techniques de pyrolyse, tout particulièrement en phase gazeuse appelée aussi CVD (« Chemical Vapor Deposition »), notamment pour un dépôt en continu sur verre float, à partir de précurseurs organo-siliciés associés à un gaz oxydant comme de l'oxygène (ou tout autre gaz plus faiblement oxydant comme $H_2O$ ou $N_2O$) dans un gaz diluant inerte du type azote, comme le diéthyle silane $Si(CH_3)_2H_2$, l'hexaméthyldisilane $(CH_3)_3Si\text{-}Si(CH_3)_3$, le tétraéthylorthosilicate $Si(OC_2H_5)_4$, l'hexaméthyldisiloxane $(CH_3)_3\text{-}Si\text{-}O\text{-}Si(CH_3)_3$, l'octaméthylcyclotétrasiloxane $((CH_3)_2SiO)_4$, le tétraméthylcyclotétrasiloxane $(CH_3HSiO)_4$, ainsi que de l'héxamathyldisilazane ou le tétraméthylsilane et/ou à partir de précurseurs organo-métalliques connus, notamment à fonction alcoolate ou β-dicétone. On peut également adopter un dépôt par pyrolyse de poudre ou en phase liquide. Pour plus de détails sur la structure et les modes d'obtention de cette couche « externe », on se rapportera avantageusement à la demande de brevet P.C.T. WO-94/25410 précitée et à la demande de brevet français FR-94/13911 correspondant au brevet européen EP-0 712 815.

La couche fonctionnelle selon l'invention est par exemple du type de celles décrites dans les demandes de brevet précitées. Ainsi, elle a généralement un indice de réfraction d'environ 1,8 à 2 et, pour garantir un niveau de performances thermiques/électriques suffisant, une épaisseur géométrique d'au moins 300 nm et notamment comprise entre 350 et 550 nm. Elle peut être à base d'oxyde(s) métallique(s) dopé(s), par exemple du type oxyde d'indium dopé à l'étain ITO, oxyde d'étain dopé au fluor $SnO_2$:F, l'oxyde de zinc dopé à l'indium ZnO:In, au fluor ZnO:F, à l'aluminium ZnO:Al ou à l'étain ZnO:Sn.

Cette couche peut être fabriquée par une technique de dépôt sous vide du type pulvérisation cathodique réactive ou non, ou à l'aide d'une technique de pyrolyse, notamment de composés pulvérulents, particulièrement lorsque la couche est en $SnO_2$:F ou en ITO et ceci directement sur le ruban de verre float de préférence, en continu.

Par pyrolyse de poudre, on peut fabriquer les couches de $SnO_2$:F à partir d'oxyde de dibutylétain (DBTO) en poudre et d'acide fluorhydrique anhydre gazeux, comme il est décrit dans le brevet FR-2 380 997, à partir de difluorure de dibutylétain (DBTF), éventuellement en mélange avec du DBTO comme décrit dans le document EP-A-178 956 ou EP-A-039 256.

En ce qui concerne les couches d'ITO, on peut les obtenir par exemple à partir de formiate d'indium et d'un composé de l'étain comme le DBTO décrit dans le document EP-A-192 009.

On peut aussi obtenir les couches de $SnO_2$:F par pyrolyse en phase gazeuse ou CVD, notamment à partir d'un mélange de composés d'étain comme $(CH_3)_2SnCl_2$, $(C_4H_9)_2SnCl_2$, $Sn(C_2H_5)_4$ et de composés organo-fluorés tels que $CCl_2F_2$, $CHClF_2$ et $CH_3CHF_2$ comme décrit dans la demande de brevet EP-A-027 403 ou bien encore à partir de monobutyl trichloroétain et d'un composé tel que le chlorodifluorométhane mentionné dans la demande de brevet EP-A-121 459, ou encore du tétrachlorure d'étain $SnCl_4$.

Les couches de $SnO_2$:F peuvent aussi être obtenues en phase liquide à partir d'acétylacétonate d'étain ou de diméthylétain-2-propionate dans des solvants organiques appropriés comme décrits notamment dans le brevet français FR-2 211 411.

Les couches d'oxyde de zinc dopé à l'indium ou à l'aluminium peuvent être obtenues par pyrolyse en phase vapeur à partir de diéthylzinc ou d'acétate de zinc et de triéthylindium, chlorure d'indium ou triéthylaluminium, chlorure d'aluminium, comme décrit dans la demande de brevet EP-A-385 769.

Avec la couche intermédiaire selon l'invention, éventuellement combinée à la couche externe, les empilements de couches minces selon l'invention sont donc très performants sur le plan thermique, esthétique et optique. Les vitrages obtenus présentent une haute transmission lumineuse, par exemple d'au moins 75%, notamment d'au moins 80 à 85%, une faible réflexion lumineuse, une couleur résiduelle en réflexion « côté couches » dans les bleus et dont la saturation C* dans le système colorimétrique (L*, a*, b*) est d'au plus égale à 5. Enfin, l'émissivité du vitrage est fortement abaissée, avec des valeurs $\varepsilon$ d'au plus 0,18.

Lorsqu'ils sont montés en double-vitrage, ils atteignent ainsi des valeurs de transmission lumineuse d'au moins 70%.

Les substrats monolithiques tels que revêtus selon l'invention peuvent avantageusement être incorporés dans des vitrages feuilletés ou dans des vitrages multiples isolants du type double-vitrage. Dans ce dernier cas, on dispose le substrat à couches dans le double-vitrage de façon à ce qu'une fois monté en façade d'un bâtiment, les couches se trouvent en face 3 (on note conventionnellement les faces des substrats des vitrages multiples en commençant par l'extérieur vers l'intérieur).

Comme déjà évoqué, tout type de technique de dépôt peut être utilisé pour procéder au dépôt de la couche fonctionnelle et de sa couche intermédiaire et éventuellement sa couche externe. Notamment, au moins une des couches lorsqu'elle est à base d'oxyde(s) métallique(s) peut être déposée(s) par une technique utilisant le vide, notamment par pulvérisation cathodique, éventuellement réactive en présence d'oxygène, à partir de cibles en alliage métallique ou en céramique de compositions appropriées.

On préfère cependant utiliser, pour le dépôt d'au moins une des couches, une technique de pyrolyse, par voie solide, liquide ou gazeuse comme déjà mentionné, car ce type de technique permet un dépôt en continu sur un ruban de verre.

Ainsi, un mode de réalisation préféré d'obtention de l'empilement selon l'invention consiste à effectuer le premier dépôt de la couche intermédiaire par CVD sur le ruban de verre dans l'enceinte float, puis à déposer la couche fonctionnelle par CVD, notamment dans l'enceinte float également, ou par pyrolyse, de composés pulvérulents, entre l'enceinte float et l'étenderie, et enfin à déposer la couche externe, soit par CVD avant l'étenderie ou dans l'étenderie, soit par pyrolyse de poudre(s) juste après le dépôt de la couche fonctionnelle.

D'autres détails et caractéristiques avantageuses ressortent de la description ci-après d'exemples de réalisation non limitatifs à l'aide des figures suivantes :

- **figure 1** : une coupe transversale d'un substrat verrier revêtu selon l'invention,
- **figure 2** : une coupe transversale d'une buse de pyrolyse en phase gazeuse adaptée pour le dépôt de la couche intermédiaire à gradient d'indice selon l'invention,
- **figures 3 à 5** : des profils « SIMS » des couches intermédiaires selon l'invention,
- **figures 6 et 7** : des graphes traduisant les gradients d'indice et de compositions chimiques des couches intermédiaires selon l'invention.

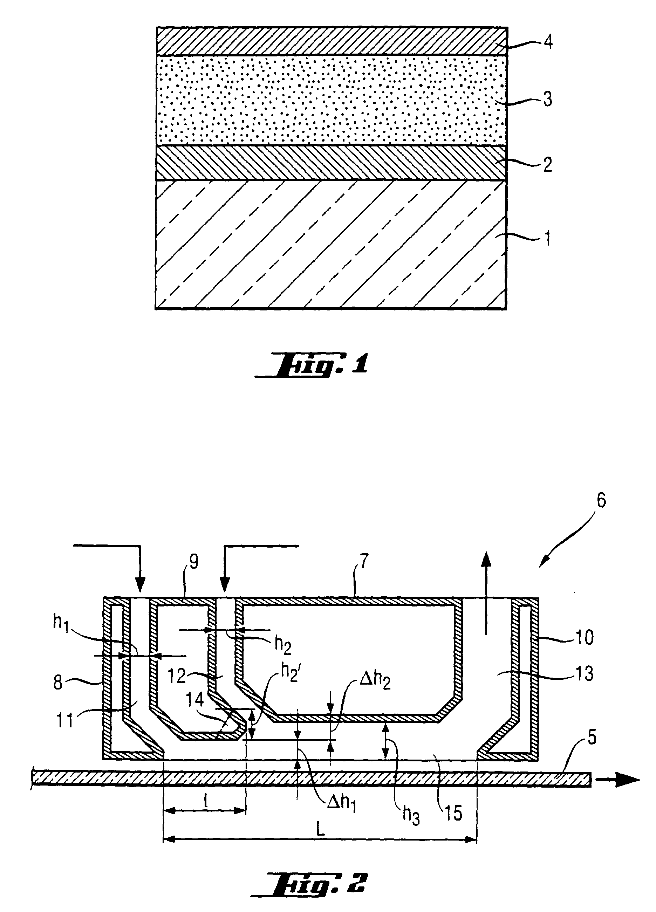

On précise qu'aussi bien la figure 1 que la figure 2 sont des représentations très schématiques ne respectant pas scrupuleusement les proportions relatives entre les divers matériaux/éléments illustrés, ceci pour faciliter leur lecture.

## EXEMPLES 1 à 7

Les exemples 1 à 7 sont réalisés selon l'invention et sont le résultat de modélisation mathématique. Ils modélisent, conformément à la figure 1, un substrat 1 en verre clair silico-sodo-calcique de 4 mm d'épaisseur. Celui-ci est revêtu d'une couche 3 bas-émissive à base de $SnO_2$:F et obtenu de manière connue par pyrolyse de poudre à partir de DBTF comme décrit dans les brevets précités, puis d'une couche externe 4, à base d'oxyde mixte de silicium et d'aluminium, avec également du fluor, couche obtenue également de manière connue par CVD à partir de tétraorthosilicate TEOS, d'hexafluoroacétylacétonate d'aluminium et d'oxygène, conformément à l'enseignement de la demande de brevet français FR-94/13911 publiée sous le numéro FR-2 727 107 correspondant au brevet EP-O 712 815. Entre le substrat 1 et la couche fonctionnelle 3, est intercalée une couche intermédiaire 2 présentant un gradient d'indice de réfraction décroissant, c'est-à-dire dont l'indice de réfraction diminue progressivement dans épaisseur, de son interface avec le verre 1 à son interface avec la couche 3 en $SnO_2$:F. Pour obtenir ce gradient, on modifie graduellement la composition chimique de la couche dans son épaisseur, couche constituée d'un mélange d'oxydes dont la proportion des composants à indice de réfraction le(s) plus élevé(s) diminue progressivement. Pour ce faire, on choisit une technique de dépôt par CVD, à l'aide de la buse de distribution illustrée en figure 2 et décrite en détails ultérieurement, à partir des précurseurs siliciés et organo-métalliques adéquats. Le composant à bas indice de la couche intermédiaire 2 est ici l'oxyde de silicium, et son précurseur gazeux peut être choisi notamment parmi le tétraéthylorthosilicate TEOS, le silane $SiH_4$ ou le tétraméthylsilane $Si(CH_3)_4$, associé(s) à un précurseur oxydant du type $O_2$, $N_2O$ ou $H_2O$.

Les composants à indice plus élevé peuvent être en oxyde d'étain, utilisant comme précurseurs gazeux le monobutyltrichlorure d'étain ou le dibutyldiacétate d'étain ; en oxyde de titane, utilisant comme précurseurs gazeux un alcoolate de titane du type tétraisopropylate de titane ; en oxyde de zirconium utilisant comme précurseurs gazeux un acétylacétonate de zirconium comme l'hexafluoroacétylacétonate de Zr ou le tétrabutoxyde de zirconium ; ou enfin l'oxyde d'aluminium utilisant comme précurseurs gazeux l'acétylacétonate ou l'hexafluoroacétylacétonate d'aluminium. Il peut aussi s'agir d'oxyde de magnésium MgO, on utilise alors un précurseur gazeux du type acétylacétonate de magnésium, éthylate de magnésium, hexafluoroacétylacétonate de magnésium, trifluoroacétylacétonate de magnésium. On peut aussi choisir de l'oxyde de vanadium $V_2O_5$, que l'on peut obtenir à partir d'un alcoolate de vanadium comme le tétraéthylate de vanadium ou d'un halogénure comme $VCl_5$ ou un oxychlorure comme $VOCl_3$. Il peut aussi s'agir de l'oxycarbure de silicium $SiO_xC_y$ dont on règle l'indice de réfraction en ajustant son taux de carbone. Les précurseurs peuvent être notamment un mélange de silane, d'éthylène et d'un oxydant comme $O_2$, $H_2O$ ou $N_2O$. Enfin, on peut aussi choisir du nitrure de silicium $Si_3N_4$, que l'on peut obtenir à partir d'un mélange gazeux de silane et d'ammoniac et/ou d'amine.

Le mode de réalisation utilisé pour ces exemples est un système bi-composant où la composition de la couche intermédiaire varie d'une composition proche de celle de l'oxyde d'étain jusqu'à une composition proche de celle de l'oxyde de silicium.

Mais un autre système bi-composant du type $SiO_2/MgO$, $SiO_2/V_2O_5$, $SiO_2/TiO_2$, $SiO_2/ZrO_2$, $SiO_2/SiO_xC_y$ ou $SiO_2/SiC$ convient également, ainsi qu'un système tri-composant où l'on part, par exemple, d'un mélange $Al_2O_3/TiO_2$ près du verre pour aboutir à une composition du type $SiO_2$.

Dans tous ces exemples, la couche 2 fonctionnelle a une épaisseur géométrique de 410 nm et la couche 4 externe une épaisseur géométrique d'environ 93 nm.

Le tableau 1 ci-dessous résume, pour chacun de ces exemples, l'épaisseur géométrique e de la couche intermédiaire, sa variation totale d'indice de réfraction dans son épaisseur notée $\Delta$ i.r. ainsi que son indice le plus faible, à proximité de la couche fonctionnelle 3 notée i.r. (min) et son indice le plus fort, du côté du substrat 1 noté i.r. (max).

## TABLEAU 1

|  | e | $\Delta$ i.r. | i.r. (min) | i.r. (max). |
|---|---|---|---|---|
| Exemple 1 | 60 nm | 0,35 | 1,50 | 1,85 |
| Exemple 2 | 60 nm | 0,30 | 1,50 | 1,80 |
| Exemple 3 | 60 nm | 0,25 | 1,50 | 1,75 |
| Exemple 4 | 60 nm | 0,5 | 1,45 | 1,95 |
| Exemple 5 | 60 nm | 0,21 | 1,63 | 1,84 |
| Exemple 6 | 54 nm | 0,35 | 1,45 | 1,80 |
| Exemple 7 | 66 nm | 0,35 | 1,45 | 1,80 |

On regroupe ci-après dans le tableau 2 des données spectro-photométriques mesurées d'après l'illuminant $D_{65}$ concernant l'ensemble des substrats revêtus selon ces exemples. Les abréviations utilisées qui résument les propriétés colorimétriques en réflexion des substrats « côté couches » ont la signification suivante :

- a*, b* sont les facteurs du système de colorimétrie (L*, a*, b*),
- C* est, toujours dans ce système, la valeur de saturation égale à $(a^{*2} + b^{*2})^{1/2}$,
- $\Delta$C* est la variation de saturation observée quand l'épaisseur de la couche fonctionnelle 2 varie de $\pm$ 50 nm autour de sa valeur moyenne de 410 nm.

Tous les substrats revêtus selon les exemples ont par ailleurs une haute transmission lumineuse $T_L$ de l'ordre de 86% et une faible réflexion lumineuse « côté couches » de l'ordre de 4 à 5%.

## TABLEAU 2

|  | a* | b* | C* | $\Delta$C* |
|---|---|---|---|---|
| **Exemple 1** | 1,6 | - 4,0 | 4,3 | 2 |
| **Exemple 2** | 1,9 | - 4,4 | 4,8 | 2,4 |
| **Exemple 3** | 1,7 | - 5,0 | 5,1 | 2,3 |
| **Exemple 4** | 2,6 | - 4,3 | 5 | 3,6 |
| **Exemple 5** | 1,9 | - 3,8 | 4,2 | 3,3 |
| **Exemple 6** | 1,6 | - 5,2 | 5,4 | 3,2 |
| **Exemple 7** | 2,4 | - 5,8 | 6,2 | 2,4 |

**EXEMPLES COMPARATIFS 8 ET 9**

Ces deux exemples comparatifs modélisent un substrat 1, une couche fonctionnelle 3 et une couche externe 4 présentant les mêmes caractéristiques que dans les exemples précédents.

Par contre, dans le cas de l'exemple 8, la couche intermédiaire 2 est constituée d'un matériau $SiO_xC_y$, obtenu comme décrit dans la demande de brevet EP-0 573 325 précitée, d'indice de réfraction constant dans son épaisseur et d'environ 1,75 et d'épaisseur géométrique égale à 60 nm.

Dans le cas de l'exemple 9, la couche intermédiaire 2 est à base d'un mélange $SiO_2/SnO_2$, mais présentant un gradient d'indice de réfraction croissant, et non décroissant : son indice varie d'environ une valeur de 1,45 près du verre ($SiO_2$ pur) à une valeur d'environ 1,85 (majoritairement du $SnO_2$) près de la couche en $SnO_2$:F, son épaisseur géométrique est de 60 nm.

Le tableau 3 ci-dessous indique pour ces deux exemples comparatifs, les mêmes données photométriques que le tableau 2 précédent :

## TABLEAU 3

|  | a* | b* | C* | $\Delta$C* |
|---|---|---|---|---|
| Exemple comparatif 8 | 0,8 | - 7,2 | 7 | 6 |
| Exemple comparatif 9 | 0,5 | - 5,5 | 5,6 | 5 |

Différentes remarques peuvent être faites au vu de ces résultats.

Il ressort du tableau 2 que tous les substrats revêtus selon l'invention présentent en réflexion « côté couches » une couleur bleue (a* faiblement positif, b* négatif), valeur que l'on retrouve lorsque ces substrats revêtus sont montés en double-vitrage de façon à avoir les couches minces en face 3.

On a donc une couleur esthétique, et peu intense puisque la valeur de saturation qui y est associée reste d'au plus environ 5.

Si, d'après le tableau 3, les substrats revêtus selon les exemples comparatifs présentent également une couleur dans les bleus-violets, en revanche la teinte est plus intense puisque leur saturation dépasse nettement cette valeur de 5.

Mais ce qui ressort surtout de la comparaison de ces deux tableaux, c'est que les variations de saturation $\Delta C^*$ des exemples selon l'invention sont bien plus faibles que celles des exemples comparatifs, puisqu'elles restent d'au plus environ 3 pour des variations d'épaisseur de la couche fonctionnelle qui sont loin d'être négligeables. En fait, il va de soi que sur ligne industrielle on peut régler l'épaisseur des dépôts à des variations bien moindres que ± 50 nm, ce qui signifie que globalement, dans les conditions réelles de production industrielle, les substrats revêtus selon l'invention donnent une impression visuelle d'une très grande homogénéité, les différences restant en dessous du seuil de sensibilité de l'oeil. Cela n'est pas le cas pour les exemples comparatifs.

On peut noter aussi que l'association de la couche intermédiaire 2 avec la couche externe 4 permet d'obtenir un effet anti-reflet très prononcé, avec des valeurs de $R_L$ « côté couches » très faibles.

Venons-en maintenant à la buse selon la figure 2 qui a permis le dépôt de la couche intermédiaire à gradient.

Cette figure montre un ruban de verre 5 défilant selon un axe donné dans l'enceinte d'un bain float. Au-dessus de ce ruban, dans une zone du bain où il a acquis une stabilité dimensionnelle, est montée une buse 6 pour distribuer les précurseurs gazeux à la surface du verre chaud afin qu'ils réagissent et se décomposent en oxyde à son contact. La buse est disposée transversalement au ruban de verre et s'étend sur toute sa largeur. Seuls les éléments de la buse importants pour la réalisation de l'invention ont été représentés et seront ici décrits. (Pour plus de détails sur le fonctionnement général, on pourra se reporter par exemple à la demande de brevet EP-A-499 523 ou à la demande de brevet EP-A-518 755, notamment). On y voit un bloc profilé central 7, un premier talon amont 8, un second talon amont 9 et un talon aval 10. Ces appellations « d'amont » et « d'aval » ont été choisies par commodité, elles se définissent en fonction du sens de défilement du verre. Entre le premier talon amont 8 et le second 9, est créée une première fente d'alimentation 11, et entre le second talon amont et le profilé central 7 est créée une seconde fente d'alimentation 12 en gaz précurseurs. Entre le bloc central 7 et le talon aval 10, est disposée une fente d'évacuation 13 associée en partie supérieure à un système d'aspiration, afin de capter les effluents gazeux n'ayant pas réagi. L'ensemble de ces fentes et les faces inférieures du second talon amont et du bloc profilé central 7 permettent d'amener les gaz à circuler le long de la surface du ruban de verre sur une longueur L correspondant à la zone de dépôt 15. Pour pouvoir obtenir un gradient d'indice, plusieurs conditions sont à réunir.

D'abord chacune des fentes est à alimenter avec un mélange de gaz précurseurs « complet », c'est-à-dire possédant à lui seul tous les composants nécessaires à l'obtention de l'oxyde recherché.

Ainsi, la première fente 11 est alimentée par le mélange réactionnel adapté pour le dépôt de $SnO_2$, soit le monobutyltrichlorure d'étain associé à un oxydant « doux » du type $H_2O$ ou $N_2O$ ou encore du dibutyldiacétate d'étain et transporté à l'aide d'un gaz vecteur inerte du type azote. La seconde fente 12 est alimentée par le mélange réactionnel adapté pour le dépôt de l'oxyde à l'indice le plus faible, ici le $SiO_2$, soit du TEOS associé également à un oxydant « doux » du type $H_2O$ ou $N_2O$.

Cependant, il est à noter que des modifications peuvent être apportées à ce principe. Ainsi, si l'on choisit, pour créer une couche intermédiaire à gradient, non pas le système $SnO_2/SiO_2$ mais le système $SiO_xC_y/SiO_2$, on peut choisir d'alimenter une des deux fentes d'injection avec le mélange « complet » de précurseurs pour faire du $SiO_2$, notamment un mélange TEOS et oxydant dans un gaz inerte, et l'autre fente d'injection soit avec le mélange « complet » de précurseurs pour faire du $SiO_xC_y$, notamment un mélange $SiH_4$ + éthylène dans un gaz inerte, soit simplement avec de l'éthylène, source de carbone, (la variation du taux de carbone dans la couche gouvernant sa variation d'indice).

Ensuite, il faut favoriser le mélange partiel, et contrôlé, des deux veines gazeuses issues de chacune de ces fentes circulant le long du verre. Pour ce faire, différents paramètres géométriques sont à régler.

D'une part la distance I, mesurée parallèlement à l'axe de défilement du verre, entre les deux fentes d'alimentation 11 et 12. On la choisit ici d'une valeur telle que $1/l = 0,27$ environ.

D'autre part, la configuration relative des différents talons et du bloc central est importante : on dispose d'abord la buse de manière à ce que les faces inférieures du premier talon amont 8 et du talon aval 10 soient très proches de la surface du verre, par exemple d'une distance de 2 à 5 mm, afin de garantir le confinement des gaz dans la zone de dépôt. On configure aussi les faces inférieures des talons amont et du bloc central de manière à ce que le second talon amont 9 soit surélevé par rapport au premier talon amont 8 d'une hauteur $\Delta h_1$, et à ce que le bloc central 7 soit surélevé par rapport au second talon amont 9 d'une hauteur $\Delta h_2$ (on choisit par exemple $\Delta h_1 \approx \Delta h_2 \approx 4$ mm).

Ensuite, on configure de manière adaptée le « nez » du second talon amont 9 (on définit par « nez » du talon 9, la zone du talon qui se trouve la plus proche de la surface du verre 5 et qui délimite l'endroit où la fente d'injection 12 débouche dans la zone de dépôt 15).

En fait, le mode de fonctionnement de la buse pour obtenir le gradient est le suivant : la première veine gazeuse de précurseurs provient de la première fente d'injection 11 qui a une section $h_1$. La seconde veine gazeuse de précurseurs provient de la seconde fente d'injection 12 qui a une section $h_2$, et la hauteur de la zone de dépôt 15 mesurée entre le plan défini par les faces inférieures du premier talon amont 8 et du talon aval 10 et le bloc central 7 a une valeur $h_3$.

Pour garantir un écoulement laminaire des deux veines gazeuses le long du verre dans la zone de dépôt 15, on respecte la relation :

$$(1) \qquad h_1 + h_2 = h_3$$

(ou $\Delta h_1 + \Delta h_2 = h_3$, on choisit ici $h_1 = \Delta h_1$ et $h_2 = \Delta h_2$)

Ici, on choisit $h_1 \approx h_2$ et chacune de ces hauteurs comprise entre 2 mm et 8 mm, notamment d'environ 4 mm, $h_3$ est alors d'environ 8 mm.

Mais si on respecte la relation (1) dans toute la zone de dépôt, on va obtenir en fait deux couches superposées, l'une en $SnO_2$, l'autre en $SiO_2$ sans vraiment obtenir le gradient voulu. Pour obtenir le gradient, il faut en fait créer localement une zone de turbulence dans la zone de dépôt 15, tout particulièrement dans la zone où débouche la seconde fente d'injection 12 dans cette zone 15. Pour ce faire, on adopte une forme de nez de talon 9 telle qu'elle provoque à ce niveau un élargissement local de la section $h_2'$ de la fente.

Les formes de « nez » appropriées peuvent par exemple être, comme représenté à la figure, des formes bizeautées, à pans coupés, ou des formes plus ou moins arrondies (les lignes en pointillés sur la figure 2 indiquent un autre type de profil envisageable).

De fait, à cet endroit, la hauteur de zone de dépôt devient égale à $h_1 + h_2'$, c'est-à-dire supérieure à $h_3$.

Les veines de gaz se mélangent alors partiellement, d'où la création du gradient. En fait, plus l'élargissement local $h_2'$ est important, plus il va y avoir de mélanges entre les deux veines gazeuses et plus l'interdiffusion entre les différents précurseurs va être grande.

Donc dans la zone I de la zone de dépôt, seuls les précurseurs d'oxyde d'étain sont au contact du verre, il se dépose donc d'abord une fine couche de $SnO_2$ quasi pure. Puis, à partir de la fin de cette zone I, réagissant ensemble les deux mélanges réactionnels, le dépôt s'appauvrissant progressivement en $SnO_2$ pour s'enrichir en $SiO_2$.

La buse selon l'invention permet donc l'obtention de couches présentant un gradient d'indice de réfraction et/ou de composition chimique. En choisissant l'ordre avec lequel on introduit les précurseurs dans les fentes d'injection successives, on peut ainsi obtenir des couches présentant dans leur épaisseur un indice croissant ou décroissant.

### EXEMPLES 10 à 12

Ces exemples ont été réalisés avec la buse décrite précédemment, en déposant sur un substrat de verre silico-sodo-calcique de 4 mm d'épaisseur des couches à base de $SnO_2/SiO_2$ dont l'indice de réfraction décroît au fur et à mesure que l'on s'éloigne du verre.

La première fente 11 est alimentée en dibutyldiacétate d'étain DBTA, et la seconde fente 12 en TEOS.

Le tableau 4 ci-dessous indique, pour ces trois exemples, le rapport R des débits volumiques entre le TEOS et le DBTA, l'épaisseur e en nm de la couche et les valeurs i.r.(min) et i.r(max) selon les conventions reprises du tableau 1 :

### TABLEAU 4

|  | R | e | i.r. (min) | i.r. (max). |
|---|---|---|---|---|
| Exemple 10 | 66 | 60 | 1,46 | 1,75 |
| Exemple 11 | 16 | 100 | 1,48 | 1,98 |
| Exemple 12 | 26 | 90 | 1,46 | 1,80 |

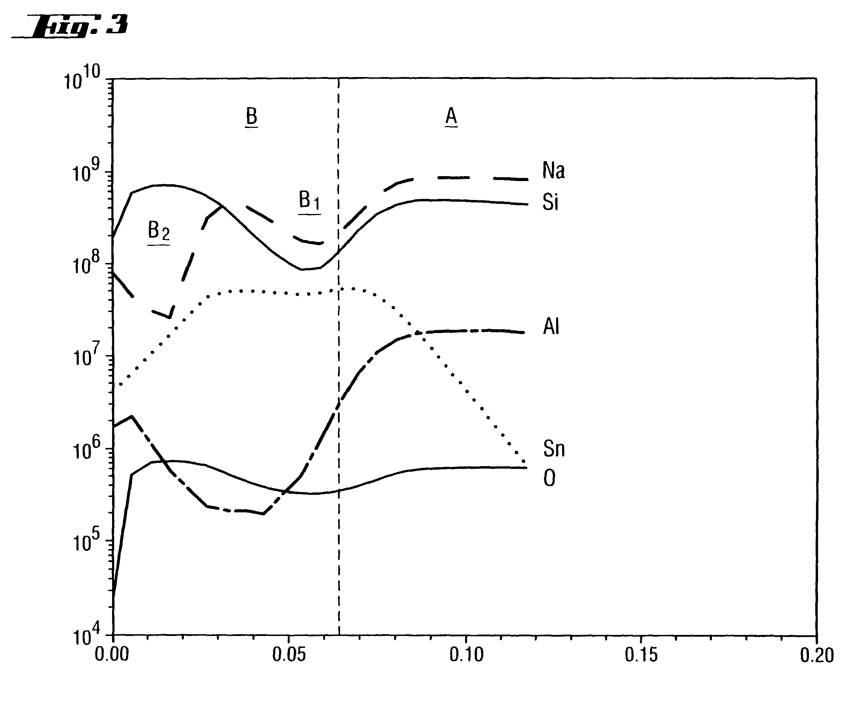

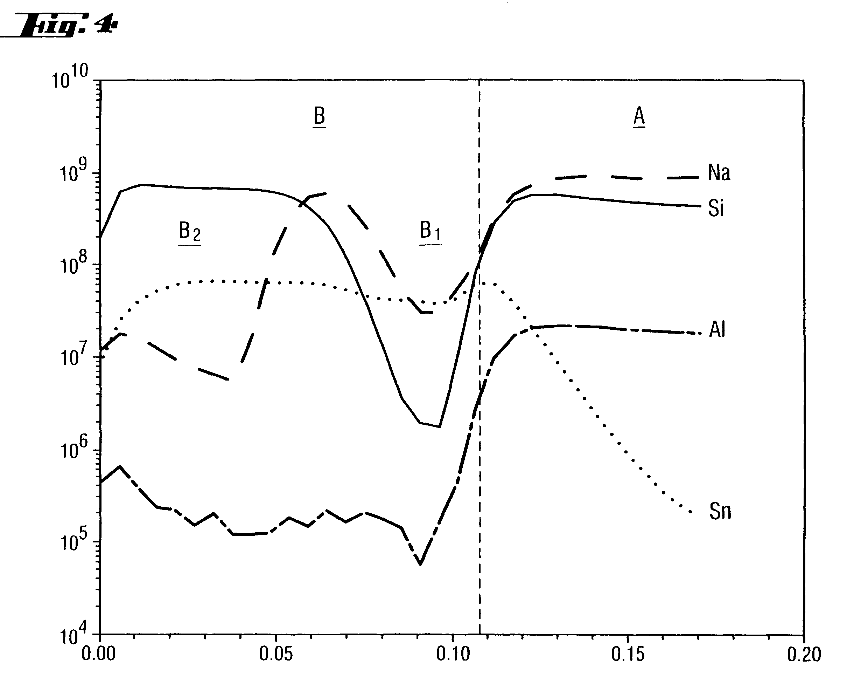

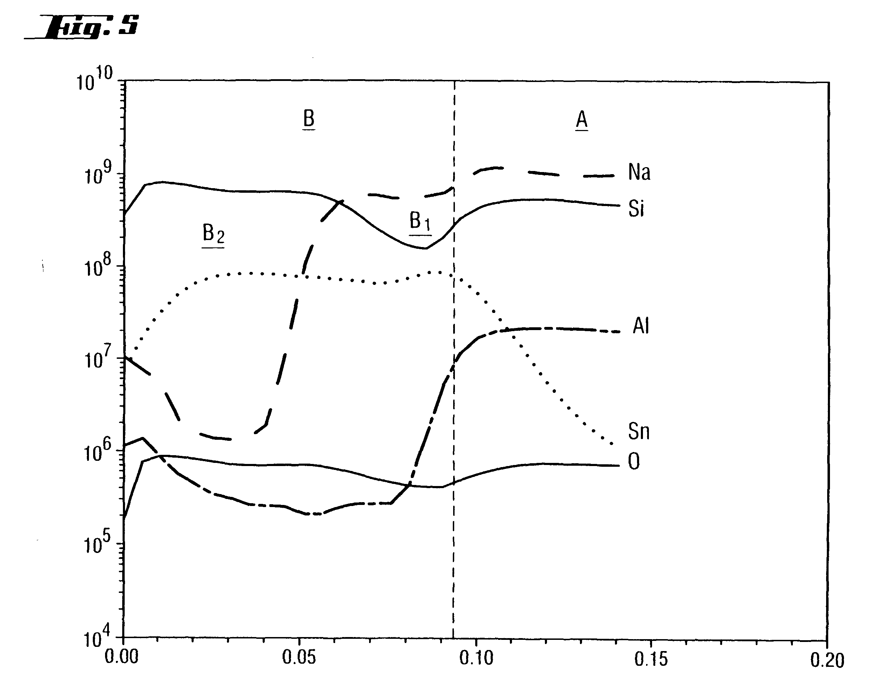

Ces trois substrats ainsi recouverts ont été analysés par SIMS (Secondary Ion Mass Spectroscopy) : les figures 3, 4 et 5 correspondent respectivement aux couches selon les exemples 10, 11 et 12. Les graphes représentent, en abscisse, la profondeur de l'analyse en micromètres, et, en ordonnée, le nombre de coups par seconde à l'échelle logarithmique.

Seuls les éléments intéressant plus particulièrement l'invention figurent dans ces trois graphes.

De leur lecture, on peut voir que l'on peut distinguer deux zones, la zone A qui correspond au verre, et la zone B à la couche. Dans la zone B, on a la zone $B_1$ la partie de la couche la plus riche en oxyde d'étain et la zone $B_2$ la partie de la couche la plus riche en oxyde de silicium.

En étudiant les variations en teneur de sodium, on peut voir que la couche selon l'invention, plus particulièrement dans sa zone $B_2$, permet de faire barrière à la diffusion de cet élément.

La teneur en aluminium permet de repérer l'interface verre/couche.

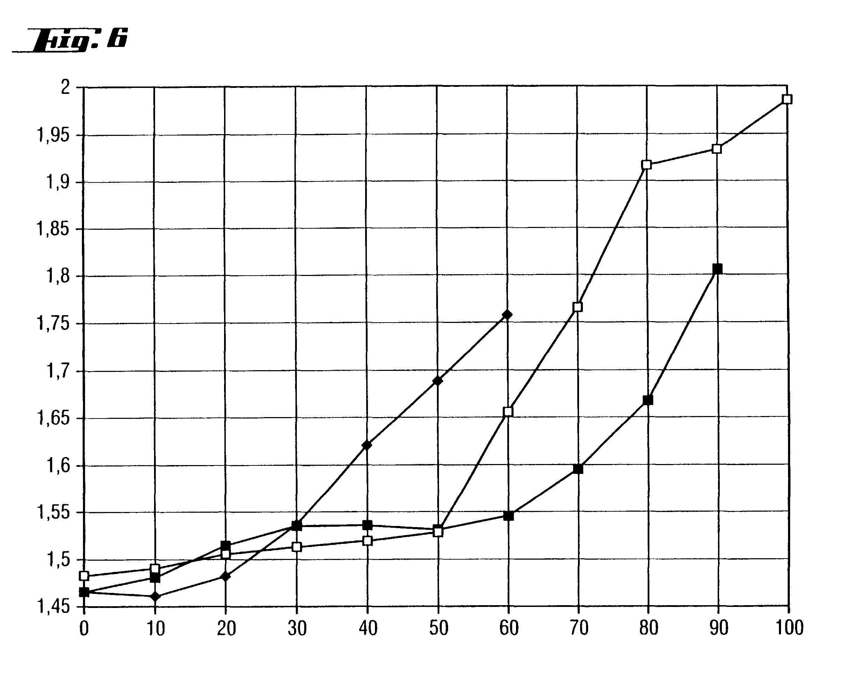

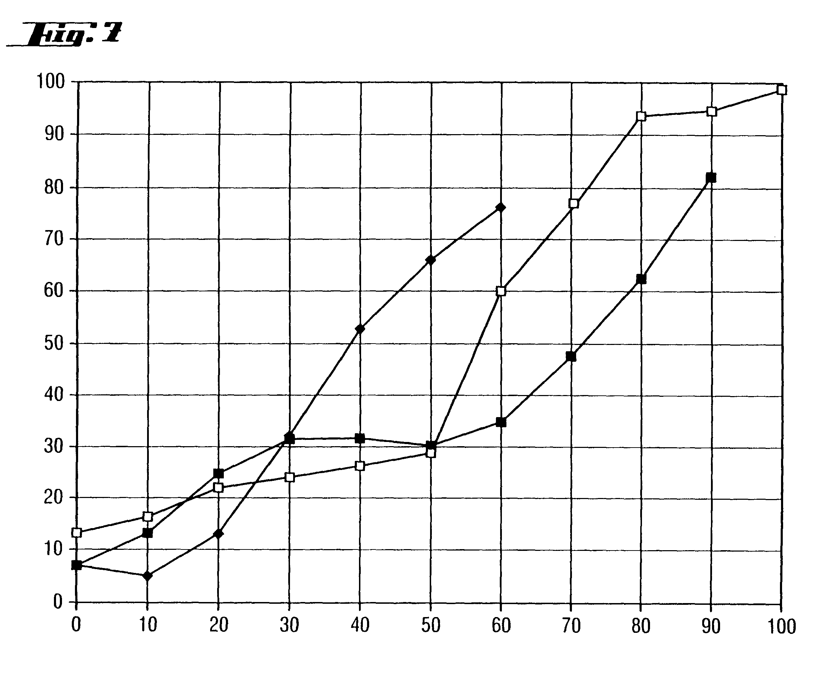

Les figures 6 et 7 sont obtenues par calcul à partir de ces analyses spectroscopiques. Dans les deux figures, les courbes repérées par des losanges noirs correspondent à l'exemple 10, celles repérées par des carrés blancs à l'exemple 11, et celles repérées par des carrés noirs à l'exemple 12. Sur la figure 6, on a en abscisse l'épaisseur de la couche en nanomètre, et en ordonnée son indice de réfraction. Sur la figure 7, on a toujours en abscisse l'épaisseur de la couche en nanomètre, et en ordonnée le pourcentage pondéral en $SnO_2$ dans la couche.

Ces deux séries de graphes montrent clairement l'effet de gradient d'indice et de composition chimique recherché dans l'invention.

L'invention se prête à tous les modes de réalisation. On peut en effet sélectionner l'épaisseur de la couche, sa variation d'indice ou de composition en ajustant par exemple des paramètres de dépôt tel que le rapport de débit entre précurseurs, la vitesse de défilement du verre sous la buse, la structure de la buse, ... .

C'est dans le cas que l'exemple 11 que l'on a le gradient d'indice et de composition le plus fort avec, à proximité de l'interface avec le verre, un taux supérieur à 90% en SnO$_2$.

Dans l'exemple 12, on voit que même à proximité du verre, la couche contient déjà moins de 80% de SiO$_2$.

## Revendications

1. Vitrage comprenant un substrat (1) transparent, notamment en verre, muni d'au moins une couche mince (3) transparente fonctionnelle, conductrice et/ou bas-émissive, **caractérisé en ce qu'**afin d'améliorer l'aspect optique et notamment colorimétrique du vitrage, se trouve disposée entre le substrat (1) et la couche fonctionnelle (3) au moins une couche intermédiaire (2) présentant dans son épaisseur un gradient d'indice de réfraction décroissant c'est à dire qui diminue au fur et à mesure que l'on s'éloigne de la surface dudit substrat transparent (1).

2. Vitrage selon la revendication 1, **caractérisé en ce que** la variation totale d'indice de réfraction dans l'épaisseur de la couche intermédiaire (2) est d'au moins 0,2, notamment comprise entre 0,25 et 0,80.

3. Vitrage selon la revendication 1 ou la revendication 2, **caractérisé en ce que** l'indice de réfraction le moins élevé dans le gradient d'indice de la couche intermédiaire (2) est compris entre 1,45 et 1,60.

4. Vitrage selon l'une des revendications précédentes, **caractérisé en ce que** l'indice de réfraction le plus élevé dans le gradient d'indice de la couche intermédiaire est compris entre 1,7 et 2,35.

5. Vitrage selon l'une des revendications précédentes, **caractérisé en ce que** l'indice de réfraction de la couche intermédiaire (2) varie d'un indice de réfraction proche de celui de la couche fonctionnelle (3) à un indice de réfraction proche de celui du substrat (1).

6. Vitrage selon l'une des revendications précédentes, **caractérisé en ce que** l'épaisseur géométrique de la couche intermédiaire (2) à gradient d'indice est compris entre 40 et 120 nm, notamment entre 50 et 100 nm.

7. Vitrage selon l'une des revendications précédentes, **caractérisé en ce que** le gradient d'indice de réfraction de la couche intermédiaire(2) est obtenu par une variation progressive de sa composition chimique, notamment par mélange d'au moins deux composants à indices de réfraction différents, le taux de composant ou du mélange de composant(s) à indice(s) le(s) plus élevé(s) décroissant graduellement dans l'épaisseur de la couche.

8. Vitrage selon la revendication 7, **caractérisé en ce que** le mélange comprend au moins un composant à indice peu élevé à base d'oxyde, oxynitrure ou oxycarbure de silicium.

9. Vitrage selon la revendication 7 ou la revendication 8, caractérisé en ce que le mélange comprend au moins un composant à indice élevé, choisi à base d'oxyde d'étain, d'oxyde de titane, d'oxyde de zirconium, d'oxyde d'aluminium, d'oxyde de magnésium, d'oxyde de vanadium, de nitrure de silicium ou d'oxycarbure de silicium.

10. Vitrage selon l'une des revendications précédentes, **caractérisé en ce que** la couche fonctionnelle (3) est revêtue d'au moins une couche mince externe (4), d'indice de réfraction compris entre 1,4 et 1,7 et d'épaisseur géométrique compris entre 70 et 120 nm.

11. Vitrage selon la revendication 10, **caractérisé en ce que** la couche externe (4) est en matériau diélectrique, à base d'au moins un des composés du groupe comprenant l'oxyde, l'oxycarbure ou l'oxynitrure de silicium, l'oxyde d'aluminium, un mélange d'oxyde mixte de silicium et d'aluminium et contenant du fluor.

12. Vitrage selon l'une des revendication précédentes, **caractérisé en ce que** la couche fonctionnelle (3) a un indice de réfraction d'environ 1,8 à 2 et une épaisseur géométrique d'au moins 300 nm, notamment compris entre 350 et 550 nm.

**13.** Vitrage selon l'une des revendications précédentes, **caractérisé en ce que** la couche fonctionnelle (3) est à base d'oxyde(s) métallique(s) dopé(s) appartenant au groupe comprenant l'oxyde d'indium dopé à l'étain ITO, l'oxyde d'étain dopé au fluor SnO$_2$:F, l'oxyde de zinc dopé à l'indium ZnO:In, au fluor ZnO:F, à l'aluminium ZnO:Al ou à l'étain ZnO:Sn.

**14.** Vitrage selon l'une des revendications précédentes, **caractérisé en ce qu'**il présente en réflexion côté couches une couleur résiduelle dans les bleus dont la saturation C* dans le système colorimétrique (L*, a*, b*) est d'au plus égale à 5, une haute transmission lumineuse T$_L$ d'au moins 75%, notamment d'au moins 80 à 85% et une émissivité ε d'au plus 0,18.

**15.** Buse (6) pour la formation par pyrolyse en phase gazeuse d'une couche à gradient d'indice de réfraction, telle que la couche intermédiaire (2) conforme à l'une des revendications précédentes, sur du verre (5) se déplaçant selon un axe tel qu'un ruban de verre dans l'enceinte d'un bain de flottage, la buse s'étendant transversalement à l'axe de défilement du verre, **caractérisée en ce qu'**elle comporte un premier talon amont (8), un second talon amont (9), un bloc profilé central (7) et un talon aval (10), une première fente d'injection (11) de gaz précurseur(s) définie entre les deux talons amont et une seconde d'injection (12) de gaz précurseur(s) de composition différente définie entre le talon amont (9) et le bloc profilé central (7), une fente d'évacuation (13) des effluents gazeux définie entre le bloc profilé central (7) et le talon aval (10), l'ensemble des fentes (11, 12, 13) et les faces inférieures des talons et du bloc central guidant les veines de gaz alimentant les fentes d'injection le long du verre dans la zone de dépôt (15) avec un trajet d'écoulement ayant approximativement la forme d'un U, la distance I entre les deux fentes d'injection (11, 12) et les configurations relatives du premier talon amont (8), du second talon amont (9) et du bloc central (7) étant choisies afin de provoquer un mélange partiel et progressif entre les deux veines gazeuses dans ladite zone de dépôt (15).

**16.** Buse (6) selon la revendication 15, **caractérisée en ce que** la face inférieure du bloc central (7) est surélevée par rapport à la face inférieure du second talon amont (9) elle-même surélevée par rapport à la face inférieure du premier talon amont (8).

**17.** Buse (6) selon la revendication 15 ou 16, **caractérisée en ce que** la distance I entre les deux fentes d'injection est d'au plus égale aux 3/4 de la longueur totale de la zone de dépôt L, et notamment d'environ 1/4 à 2/3 de ladite longueur L.

**18.** Buse (6) selon l'une des revendications 15 à 17, **caractérisée en ce que** la première fente d'injection (11) est alimentée avec un mélange réactionnel gazeux se décomposant sous forme d'un oxyde d'indice de réfraction donné **et en ce que** la seconde fente d'injection (12) est alimentée avec un mélange réactionnel gazeux se décomposant sous forme d'un oxyde d'indice de réfraction différent du précédent, notamment inférieur.

**19.** Buse (6) selon l'une des revendications 15 à 18, **caractérisée en ce que** le second talon amont (8) est configuré de manière à créer un élargissement localisé de la seconde fente d'injection (12) à proximité de la zone de dépôt (15).

**20.** Buse (6) selon la revendication 19, **caractérisée en ce que** le nez (14) du second talon amont (8) présente un profil à pans coupés ou arrondis, de façon à élargir la fente d'injection (12) dans la zone où elle débouche dans la zone de dépôt (15).

**21.** Procédé de mise en oeuvre de la buse (6) selon l'une des revendications 15 à 20, **caractérisé en ce qu'**on alimente la première fente d'injection (11) avec un premier mélange réactionnel gazeux et la seconde fente d'injection (12) avec un second mélange gazeux, de manière à ce que les veines gazeuses issues de ces deux mélanges circulent dans la zone de dépôt (15) le long du verre selon un écoulement laminaire, sauf localement à la sortie de la seconde fente d'injection (12) où l'on crée une zone de turbulence destinée à faciliter l'interdiffusion des deux veines gazeuses.

**Claims**

**1.** Glazing comprising a transparent substrate (1), particularly of glass, provided with at least one transparent, functional, conductive and/or low emissive, thin layer (3), characterized in that in order to improve the optical and in particular colorimetric appearance of the glazing, between the substrate (1) and the functional layer (3) is placed at least one intermediate layer (2) having in its thickness a decreasing refractive index, i.e. which decreases on moving away from the surface of said transparent substrate (1).

2. Glazing according to claim 1, characterized in that the total refractive index variation in the thickness of the intermediate layer (2) is at least 0.2 and in particular between 0.25 and 0.80.

3. Glazing according to claim 1 or 2, characterized in that the lowest refractive index in the index gradient of the intermediate layer (2) is between 1.45 and 1.60.

4. Glazing according to one of the preceding claims, characterized in that the highest refractive index in the index gradient of the intermediate layer is between 1.7 and 2.35.

5. Glazing according to one of the preceding claims, characterized in that the refractive index of the intermediate glazing (2) varies from a refractive index close to that of the functional layer (3) to a refractive index close to that of the substrate (1).

6. Glazing according to one of the preceding claims, characterized in that the geometrical thickness of the intermediate layer (2) having at the index gradient is between 40 and 120 nm, particularly between 50 and 100 nm.

7. Glazing according to one of the preceding claims, characterized in that the refractive index gradient of the intermediate layer (2) is obtained by progressively varying its chemical composition, particularly by mixing at least two components having different refractive indices, the content of the component or mixture of components having the highest index or indices gradually decreasing in the thickness of the layer.

8. Glazing according to claim 7, characterized in that the mixture incorporates at least one component with a not very high index based on oxide, silicon oxycarbide or oxynitride.

9. Glazing according to claim 7 or 8, characterized in that the mixture incorporates at least one component with a high index, based on tin oxide, titanium oxide, zirconium oxide, aluminium oxide, magnesium oxide, vanadium oxide, silicon nitride or silicon oxycarbide.

10. Glazing according to one of the preceding claims, characterized in that the functional layer (3) is coated with at least one thin, outer layer (4) having a refractive index between 1.4 and 1.7 and a geometrical thickness between 70 and 120 nm.

11. Glazing according to claim 10, characterized in that the outer layer (4) is of dielectric material, based on at least one of the compounds from within the group including oxide, silicon oxynitride or oxycarbide, aluminium oxide, a mixed oxide mixture of silicon and aluminium and containing fluorine.

12. Glazing according to one of the preceding claims, characterized in that the functional layer (3) has a refractive index of approximately 1.8 to 2 and a geometrical thickness of at least 300 nm, particularly between 350 and 550 nm.

13. Glazing according to one of the preceding claims, characterized in that the functional layer (3) is based on doped metal oxide or oxides belonging to the group including tin-doped indium oxide ITO, fluorine-doped tin oxide $SnO_2$:F, zinc oxide doped with indium ZnO:In, with fluorine ZnO:F, with aluminium ZnO:Al or tin ZnO:Sn.

14. Glazing according to one of the preceding claims, characterized in that in reflection on the layer side it has a residual colour in the blues, whose saturation $C^*$ in the colorimetric system ($L^*$, $a^*$, $b^*$) is at the most equal to 5, a high light transmission $T_L$ of at least 75%, particularly at least 80 to 85%, and an emissivity $\varepsilon$ of at the most 0.18.

15. Nozzle (6) for the formation by gas phase pyrolysis of a refractive index gradient layer, such as the intermediate layer (2) according to one of the preceding claims, on the glass (5) travelling in accordance with an axis like that of a glass ribbon in the tank of a float bath, the nozzle extending transversely to the glass movement axis, characterized in that it has a first upstream heel (8), a second upstream heel (9), a central, profiled block (7) and a downstream heel (10), a first precursor gas injection slot (11) defined between the two upstream heels and a second injection slot (12) for precursor gas or gases of different composition defined between the upstream heel (9) and the central, profiled block (7), a gaseous effluent discharge slot (13) defined between the central, profiled block (7) and the downstream heel (10), all the slots (11, 12, 13) and the lower faces of the heels and the central block guiding the gas jets supplying the injection slots along the glass in the deposition area (15) with an approximately U-shaped flow path, the distance I between the two injection slots (11, 12) and the relative configurations of the first upstream heel (8), the second upstream heel (9) and the central block (7) being chosen so as to bring about a partial and progressive mixing between the two gas jets in said deposition zone (15).

16. Nozzle (6) according to claim 15, characterized in that the lower face of the central block (7) is raised compared with the lower face of the second upstream heel (9), which is itself raised compared with the lower face of the first upstream heel (8).

17. Nozzle (6) according to claim 15 or 16, characterized in that the distance I between the two injection slots is at the most 3/4 of the total length of the deposition zone L and in particular approximately 1/4 to 2/3 of said length L.

18. Nozzle (6) according to one of the claims 15 to 17, characterized in that the first injection slot (11) is supplied with a gaseous reaction mixture decomposing in the form of an oxide with a given refractive index and in that the second injection slot (12) is supplied with a gaseous reaction mixture decomposing in the form of an oxide having a different and in particular lower refractive index to the first slot.

19. Nozzle (6) according to one of the claims 15 to 18, characterized in that the second upstream heel (18) is configured so as to create a local widening of the second injection slot (12) in the vicinity of the deposition zone (15).

20. Nozzle (6) according to claim 19, characterized in that the nose (14) of the second upstream heel (8) has a profile with cut or rounded faces so as to widen the injection slot (12) in the area where it issues into the deposition zone (15).

21. Method for implementing the nozzle (6) according to one of the claims 15 to 20, characterized in that the first injection slot (11) is supplied with a first gaseous reaction mixture and the second injection slot (12) with a second gaseous mixture, so that the gas jets from said two mixtures circulate in the deposition zone (15) along the glass in accordance with a laminar flow, except locally at the outlet of the second injection slot (12), where a turbulence area is created for facilitating the interdiffusion of two gas jets.

**Patentansprüche**

1. Verglasung, die ein insbesondere aus Glas bestehendes transparentes Substrat (1) enthält, das mit mindestens einer transparenten dünnen Funktionsschicht (3) versehen ist, die leitfähig und/oder niedrig emittierend ist, **dadurch gekennzeichnet, dass**, um das optische und insbesondere farbliche Aussehen der Verglasung zu verbessern, zwischen dem Substrat (1) und der Funktionsschicht (3) mindestens eine Zwischenschicht (2) angeordnet ist, die in ihrer Dicke einen abnehmenden Gradienten des Brechungsindex aufweist, d.h. der in dem Maße, in welchem man sich von der Oberfläche des transparenten Substrats (1) entfernt, kleiner wird.

2. Verglasung nach Anspruch 1, **dadurch gekennzeichnet, dass** die gesamte Veränderung des Brechungsindex in der Dicke der Zwischenschicht (2) mindestens 0,2 und insbesondere 0,25 bis 0,80 beträgt.

3. Verglasung nach Anspruch 1 oder 2, **dadurch gekennzeichnet, dass** der niedrigste Brechungsindex in dem Gradienten des Brechungsindex der Zwischenschicht (2) 1,45 bis 1,60 beträgt.

4. Verglasung nach einem der vorhergehenden Ansprüche, **dadurch gekennzeichnet, dass** der höchste Brechungsindex in dem Gradienten des Brechungsindex der Zwischenschicht 1,7 bis 2,35 beträgt.

5. Verglasung nach einem der vorhergehenden Ansprüche, **dadurch gekennzeichnet, dass** der Brechungsindex der Zwischenschicht (2) von einem Brechungsindex nahe demjenigen der Funktionsschicht (3) bis zu einem Brechungsindex nahe demjenigen des Substrats (1). variiert.

6. Verglasung nach einem der vorhergehenden Ansprüche, **dadurch gekennzeichnet, dass** die geometrische Dicke der Zwischenschicht (2) mit Brechungsindex zwischen 40 und 120 nm und insbesondere zwischen 50 und 100 nm beträgt.

7. Verglasung nach einem der vorhergehenden Ansprüche, **dadurch gekennzeichnet, dass** der Gradient des Brechungsindex der Zwischenschicht (2) durch fortschreitende Variierung ihrer chemischen Zusammensetzung, insbesondere durch Vermischen von mindestens zwei Komponenten mit unterschiedlichen Brechungsindizes, erhalten wird, wobei der Anteil der Komponente oder des Gemischs aus Komponente/n mit dem/den höchsten Brechungsindex/Brechungsindizes in der Dicke der Schicht allmählich abnimmt.

8. Verglasung nach Anspruch 7, **dadurch gekennzeichnet, dass** das Gemisch mindestens eine Komponente mit einem weniger hohen Brechungsindex auf der Basis von Siliciumoxid, -nitridoxid oder -carbidoxid enthält.

9. Verglasung nach Anspruch 7 oder 8, **dadurch gekennzeichnet, dass** das Gemisch mindestens eine Komponente mit hohem Brechungsindex enthält, die auf der Basis von Zinnoxid, Titanoxid, Zirconiumoxid, Aluminiumoxid, Magnesiumoxid, Vanadiumoxid, Siliciumnitrid oder Siliciumcarbidoxid ausgewählt ist.

10. Verglasung nach einem der vorhergehenden Ansprüche, **dadurch gekennzeichnet, dass** die Funktionsschicht (3) mit mindestens einer dünnen Außenschicht (4) mit einem Brechungsindex von 1,4 bis 1,7 und einer geometrischen Dicke von 70 bis 120 nm überzogen ist.

11. Verglasung nach Anspruch 10, **dadurch gekennzeichnet, dass** die Außenschicht (4) aus einem dielektrischen Material auf der Basis von mindestens einer der Verbindungen aus der Siliciumoxid, -carbidoxid oder -nitridoxid, Aluminiumoxid und ein fluorhaltiges Gemisch aus Silicium-Aluminium-Mischoxid umfassenden Gruppe besteht.

12. Verglasung nach einem der vorhergehenden Ansprüche, **dadurch gekennzeichnet, dass** die Funktionsschicht (3) einen Brechungsindex von etwa 1,8 bis 2 und eine geometrische Dicke von mindestens 300 nm, insbesondere 350 bis 550 nm, besitzt.

13. Verglasung nach einem der vorhergehenden Ansprüche, **dadurch gekennzeichnet, dass** die Funktionsschicht (3) auf der Basis von dotiertem/dotierten Metalloxid/en ist, das/die zu der Gruppe gehört/gehören, die mit Zinn dotiertes Indiumoxid, ITO, mit Fluor dotiertes Zinnoxid, $SnO_2$:F, und mit Indium, ZnO:In, Fluor, ZnO:F, Aluminium, ZnO:Al oder Zinn, ZnO:Sn, dotiertes Zinkoxid umfasst.

14. Verglasung nach einem der vorhergehenden Ansprüche, **dadurch gekennzeichnet, dass** sie bei reflektiertem Licht auf der beschichteten Seite eine Restfärbung im blauen Bereich, deren Sättigung $C^*$ in der Farbmetril ($L^*$, $a^*$, $b^*$) höchstens 5 beträgt, einen hohen Lichttransmissionsgrad $T_L$ von mindestens 75 %, insbesondere mindestens 80 bis 85 %, und einen Emissionskoeffizienten $\varepsilon$ von höchstens 0,18 aufweist.

15. Düse (6) für die Bildung einer Schicht mit einem Gradienten des Brechungsindex wie die Zwischenschicht (2) nach einem der vorhergehenden Ansprüche auf dem Glas (5), das sich, wie ein Glasband in der Wanne eines Floatglasbades, in einer Achse vorwärtsbewegt, durch Pyrolyse aus der Gasphase, wobei die Düse quer zur Durchlaufachse des Glases verläuft, **dadurch gekennzeichnet, dass** sie einen ersten hinteren Vorsatz (8), einen zweiten hinteren Vorsatz (9), einen stromlinienförmigen zentralen Block (7), einen vorderen Vorsatz (10), einen ersten Einblasschlitz (11) für Vorläufergas/e, der zwischen den beiden hinteren Vorsätzen gebildet ist, und einen zweiten Einblasschlitz (12) für Vorläufergas/e mit einer anderen Zusammensetzung, der zwischen dem hinteren Vorsatz (9) und dem stromlinienförmigen zentralen Block (7) gebildet ist, und einen Abzugsschlitz (13) für die Abgase, der zwischen dem stromlinienförmigen zentralen Block (7) und dem vorderen Vorsatz (10) gebildet ist, umfasst, wobei alle Schlitze (11, 12, 13) und die Unterseiten der Ansätze und des zentralen Blocks die die Einblasschlitze versorgenden Gasströme entlang des Glases im Abscheidebereich (15) mit einem Strömungsweg leiten, der näherungsweise U-förmig ist, und der Abstand 1 zwischen den beiden Einblasschlitzen (11, 12) und die relative Gestaltung des ersten hinteren Vorsatzes (8), des zweiten hinteren Vorsatzes (9) und des zentralen Blocks (7) derart gewählt ist, dass im Abscheidebereich (15) eine partielle und fortschreitende Vermischung zwischen den beiden Gasströmen stattfindet.

16. Düse (6) nach Anspruch 15. **dadurch gekennzeichnet, dass** die Unterseite des zentralen Blocks (7) im Verhältnis zur Unterseite des zweiten hinteren Vorsatzes (9) erhöht ist, die ihrerseits im Verhältnis zur Unterseite des ersten hinteren Vorsatzes (8) erhöht ist.

17. Düse (6) nach Anspruch 15 oder 16, **dadurch gekennzeichnet, dass** der Abstand 1 zwischen den beiden Einblasdüsen höchstens 3/4 der Gesamtlänge des Abscheidebereichs L und insbesondere etwa 1/4 bis 2/3 der Gesamtlänge L beträgt.

**18.** Düse (6) nach einem der Ansprüche 15 bis 17, **dadurch gekennzeichnet, dass** dem ersten Einblasschlitz (11) ein gasförmiges Reaktionsgemisch zugeführt wird, das sich zu einem Oxid mit einem gegebenen Brechungsindex zersetzt, und dass dem zweiten Einblasschlitz (12) ein gasförmiges Reaktionsgemisch zugeführt wird, das sich zu einem Oxid mit einem anderen, insbesondere kleineren Brechungsindex als dem vorhergehenden zersetzt.

**19.** Düse (6) nach einem der Ansprüche 15 bis 18, **dadurch gekennzeichnet, dass** der zweite hintere Vorsatz (8) derart gestaltet ist, dass in der Nähe des Abscheidebereichs (15) eine lokale Verbreiterung des zweiten Einblasschlitzes (12) geschaffen wird.

**20.** Düse (6) nach Anspruch 19, **dadurch gekennzeichnet, dass** die Nase (14) des zweiten hinteren Vorsatzes (8) ein Profil mit schrägen oder abgerundeten Kanten derart aufweist, dass der Einblasschlitz (12) in der Zone, in welcher er in den Abscheidebereich (15) mündet, verbreitert wird.

**21.** Verfahren zur Verwendung der Düse (6) nach einem der Ansprüche 15 bis 20, **dadurch gekennzeichnet, dass** dem ersten Einblasschlitz (11) ein erstes gasförmiges Reaktionsgemisch und dem zweiten Einblasschlitz (12) ein zweites gasförmiges Reaktionsgemisch derart zugeführt wird, dass die aus diesen zwei Gemischen entstehenden Gasströme sich, bis auf lokal am Ausgang des zweiten Einblaaschlitzes (12), wo eine turbulente Zone geschaffen wird, welche die Interdiffusion der beiden Gasströme erleichtern soll, im Abscheidebereich (15) entlang des Glases mit einer laminaren Strömung bewegen.

**Fig. 1**

**Fig. 2**

**Fig. 3**

Fig. 4

EP 0 781 257 B1

**Fig. 5**

Fig. 6

Fig. 7